(19) Europäisches Patentamt
European Patent Office
Office européen des brevets

(11) **EP 3 514 629 A1**

(12) **EUROPEAN PATENT APPLICATION**

(43) Date of publication:
**24.07.2019 Bulletin 2019/30**

(51) Int Cl.:
***G03F 7/20*** *(2006.01)*

(21) Application number: **18152891.0**

(22) Date of filing: **23.01.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **ASML Netherlands B.V.**
**5500 AH Veldhoven (NL)**

(72) Inventors:
• **BUIJNSTERS, Frank, Jaco**
**5500 AH Veldhoven (NL)**

• **DIRKS, Remco**
**5500 AH Veldhoven (NL)**
• **VAN LAARHOVEN, Hendrik, Adriaan**
**5500 AH Veldhoven (NL)**

(74) Representative: **Broeken, Petrus Henricus Johannes**
**ASML Netherlands B.V.**
**Corporate Intellectual Property**
**P.O.Box 324**
**5500 AH Veldhoven (NL)**

(54) **METHODS AND APPARATUS FOR CONSTRUCTING A PARAMETERIZED GEOMETRIC MODEL OF A STRUCTURE AND ASSOCIATED INSPECTION APPARATUS AND METHOD**

(57) Disclosed is a method for constructing a parameterized geometric model of a structure, and an associated inspection apparatus. The method comprises determining an initial contour defining a modeled surface of the structure; and determining an output contour defining the modeled surface of the structure as a Minkowski sum of the initial contour and a kernel.

Fig. 8

EP 3 514 629 A1

**Description**

FIELD

The present invention relates to metrology of microscopic structures, for example to assess critical dimensions (CD) performance of a lithographic apparatus.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., comprising part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, it is necessary to measure parameters of the patterned substrate, for example the overlay error between successive layers formed in or on it. There are various techniques for making measurements of the microscopic structures formed in lithographic processes, including the use of scanning electron microscopes and various specialized tools. One form of specialized inspection tool is a scatterometer in which a beam of radiation is directed onto a target on the surface of the substrate and properties of the scattered or reflected beam are measured. By comparing the properties of the beam before and after it has been reflected or scattered by the substrate, the properties of the substrate can be determined. This can be done, for example, by comparing the reflected beam with data stored in a library of known measurements associated with known substrate properties. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Due to the size of the structures being measured, such scatterometers cannot directly measure dimensions (e.g., critical dimension CD) of the structures. Instead, such dimensional measurements are typically made using reconstruction techniques. CD reconstruction belongs to a group of problems known under the general name of inverse scattering, in which observed data is matched to a possible physical situation. The aim is to find a physical situation that gives rise to the observed data as closely as possible. In the case of scatterometry, the electromagnetic theory (Maxwell's equations) allows one to predict what will be the measured (scattered) data for a given physical situation. This is called the forward scattering problem. The inverse scattering problem is now to find the proper physical situation that corresponds to the actual measured data, which is typically a highly nonlinear problem. To solve this inverse scattering problem, a nonlinear solver is used that uses the solutions of many forward scattering problems. In known approaches for reconstruction, the nonlinear problem is founded on three ingredients:

- minimization of the difference between measured data and data computed from the estimated scattering setup, e.g., by the Gauss-Newton method or a similar numerical algorithm;
- parameterized shapes in the scattering setup, e.g. radius and height of a contact hole;
- sufficiently high accuracy in the solution of the forward problem (e.g. computed reflection coefficients) each time the parameters are updated.

To perform such a reconstruction, a parameterized geometric model needs to be constructed. Improved methods for constructing such a parameterized geometric model are disclosed herein.

SUMMARY

According to a first aspect of the present invention, there is provided a method for constructing a parameterized geometric model of a structure comprising: determining an initial contour defining a modeled surface of the structure; and determining an output contour defining the modeled surface of the structure as a Minkowski sum of the initial contour and a kernel.

According to a second aspect of the present invention, there is provided a computer program product containing one or more sequences of machine-readable instructions, the instructions being adapted to cause one or more processors to perform a method according to the first aspect.

According to a third aspect of the present invention, there is provided an inspection apparatus comprising: projection optics for projecting measurement radiation onto a structure on a substrate; a detection arrangement operable to measure a measured response resultant from scattering of said measurement radiation by said structure; and a processor operable to: construct a parameterized geometric model of the structure using the method of the first aspect; determine an estimated response relating to the parameterized geometric model; and vary one or more parameters of the parameterized geometric model to minimize the difference between the measured response and the estimated response.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS/FIGURES

The accompanying drawings, which are incorporated herein and form part of the specification, illustrate the present invention and, together with the description, further serve to explain the principles of the invention and to enable a person skilled in the relevant art(s) to make and use the invention.

Figure 1 depicts a lithographic apparatus.
Figure 2 depicts a lithographic cell or cluster.
Figure 3 depicts a first scatterometer.
Figure 4 depicts a second scatterometer.
Figure 5 depicts a first example process using an embodiment of the invention for reconstruction of a structure from scatterometer measurements.
Figure 6 depicts a second example process using an embodiment of the invention for reconstruction of a structure from scatterometer measurements.
Figure 7 (a) and (b) illustrate two drawbacks with known methods of constructing a parameterized geometric model;
Figure 8 illustrates a method of constructing a parameterized geometric model using a Minkowski sum, according to an embodiment of the invention;
Figure 9 illustrates: (a) and (b) two further methods of constructing a parameterized geometric model using a Minkowski sum, according to embodiments of the invention; (c) a cross sectional detail of Figure 9(a); and (d) an anisotropic kernel usable in embodiments of the invention.
Figure 10 illustrates a method according to a further embodiment of the invention for modelling a structure formed by a double patterning process;
Figure 11 illustrates a method according to a further embodiment of the invention for rounding corners of a parameterized geometric modeled structure; and
Figure 12 shows (a) a periodic geometry as modeled before a rounding process according to an embodiment of the invention is applied; and (b) as modeled after a rounding process according to an embodiment of the invention is applied.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements. The drawing in which an element first appears is indicated by the leftmost digit(s) in the corresponding reference number.

DETAILED DESCRIPTION

This specification discloses one or more embodiments that incorporate the features of this invention. The disclosed embodiment(s) merely exemplify the invention. The scope of the invention is not limited to the disclosed embodiment(s). The invention is defined by the claims appended hereto.

The embodiment(s) described, and references in the specification to "one embodiment", "an embodiment", "an example embodiment", etc., indicate that the embodiment(s) described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is understood that it is within the knowledge of one skilled in the art to effect such feature, structure, or characteristic in connection with other embodiments whether or not explicitly described.

Embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

Before describing such embodiments in more detail, however, it is instructive to present example environments in which embodiments of the present invention may be implemented.

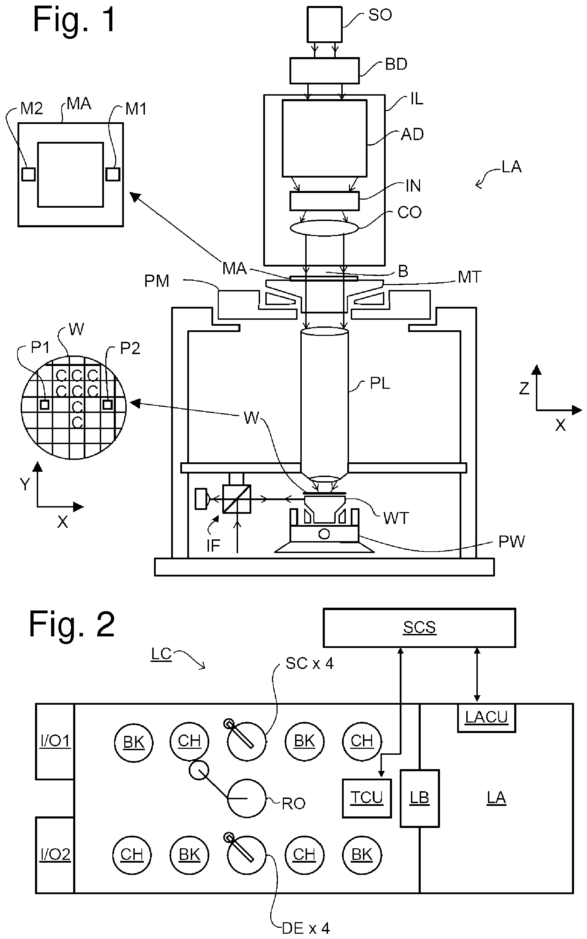

Figure 1 schematically depicts a lithographic apparatus. The apparatus comprises: an illumination system (illuminator) IL configured to condition a radiation beam B (e.g., UV radiation or DUV radiation), a support structure (e.g., a mask table) MT constructed to support a patterning device (e.g., a mask) MA and connected to a first positioner PM configured to accurately position the patterning device in accordance with certain parameters, a substrate table (e.g., a wafer table) WT constructed to hold a substrate (e.g., a resist-coated wafer) W and connected to a second positioner PW configured to accurately position the substrate in accordance with certain parameters, and a projection system (e.g., a refractive projection lens system) PL configured to project a pattern imparted to the radiation beam B by patterning device MA onto a target portion C (e.g., comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is-reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as $\alpha$-outer and $\alpha$-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PL, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the mask MA with respect to the path of the radiation beam B, e.g., after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. If errors are detected, adjustments may be made to exposures of subsequent substrates, especially if the inspection can be done soon and fast enough that other substrates of the same batch are still to be exposed. Also, already exposed substrates may be stripped and reworked - to improve yield - or discarded, thereby avoiding performing exposures on substrates that are known to be faulty. In a case where only some target portions of a substrate are faulty, further exposures can be performed only on those target portions which are good.

An inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a standalone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

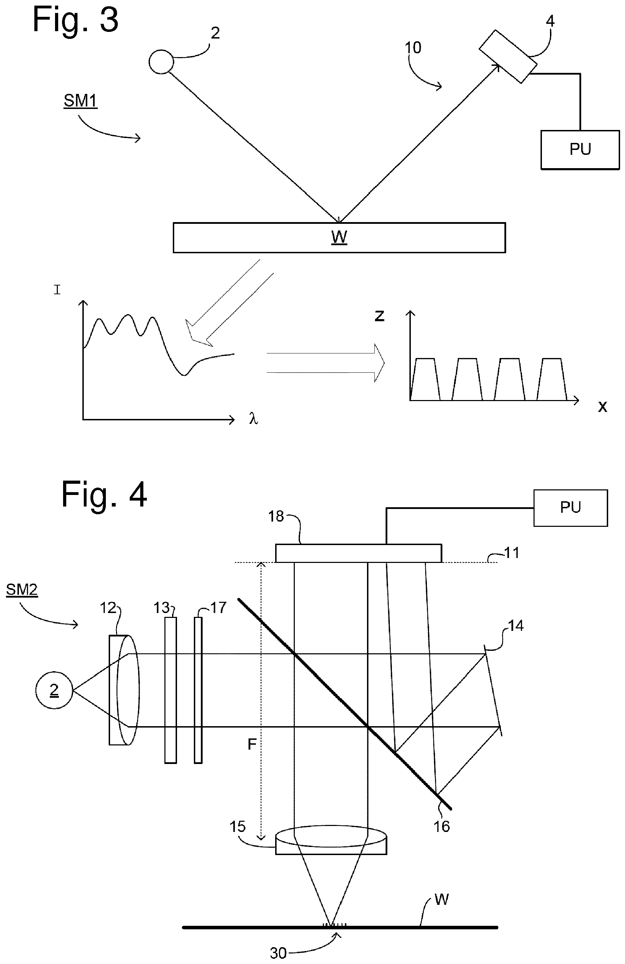

Figure 3 depicts a scatterometer which may be used in an embodiment of the present invention. It comprises a broadband (white light) radiation projector 2 which projects radiation onto a substrate W. The reflected radiation is passed to a spectrometer detector 4, which measures a spectrum 10 (intensity as a function of wavelength) of the specular reflected radiation. From this data, the structure or profile giving rise to the detected spectrum may be reconstructed by processing unit PU, e.g., conventionally by Rigorous Coupled Wave Analysis (RCWA) and non-linear regression or by comparison with a library of simulated spectra as shown at the bottom of Figure 3. In general, for the reconstruction the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Another scatterometer that may be used in an embodiment of the present invention is shown in Figure 4. In this device, the radiation emitted by radiation source 2 is focused using lens system 12 through interference filter 13 and polarizer 17, reflected by partially reflected surface 16 and is focused onto substrate W via a microscope objective lens 15, which has a high numerical aperture (NA), preferably at least 0.9 and more preferably at least 0.95. Immersion scatterometers may even have lenses with numerical apertures over 1. The reflected radiation then transmits through partially reflective surface 16 into a detector 18 in order to have the scatter spectrum detected. The detector may be located in the back-projected pupil plane 11, which is at the focal length of the lens system 15, however the pupil plane may instead be re-imaged with auxiliary optics (not shown) onto the detector. The pupil plane is the plane in which the radial position of radiation defines the angle of incidence and the angular position defines azimuth angle of the radiation. The detector is preferably a two-dimensional detector so that a two-dimensional angular scatter spectrum of a substrate target 30 can be measured. The detector 18 may be, for example, an array of CCD or CMOS sensors, and may use an integration time of, for example, 40 milliseconds per frame.

A reference beam is often used for example to measure the intensity of the incident radiation. To do this, when the radiation beam is incident on the beam splitter 16 part of it is transmitted through the beam splitter as a reference beam towards a reference mirror 14. The reference beam is then projected onto a different part of the same detector 18.

A set of interference filters 13 is available to select a wavelength of interest in the range of, say, 405 - 790 nm or even lower, such as 200 - 300 nm. The interference filter may be tunable rather than comprising a set of different filters. A grating could be used instead of interference filters.

The detector 18 may measure the intensity of scattered light at a single wavelength (or narrow wavelength range), the intensity separately at multiple wavelengths or integrated over a wavelength range. Furthermore, the detector may separately measure the intensity of transverse magnetic- and transverse electric-polarized light and/or the phase difference between the transverse magnetic- and transverse electric-polarized light.

Using a broadband light source (i.e. one with a wide range of light frequencies or wavelengths - and therefore of colors) is possible, which gives a large etendue, allowing the mixing of multiple wavelengths. The plurality of wavelengths in the broadband preferably each has a bandwidth of $\Delta\lambda$ and a spacing of at least $2\,\Delta\lambda$ (i.e. twice the bandwidth). Several "sources" of radiation can be different portions of an extended radiation source which have been split using fiber bundles. In this way, angle resolved scatter spectra can be measured at multiple wavelengths in parallel. A 3-D spectrum (wavelength and two different angles) can be measured, which contains more information than a 2-D spectrum. This allows more information to be measured which increases metrology process robustness. This is described in more detail in EP1,628,164A.

The target 30 on substrate W may be a grating, which is printed such that after development, the bars are formed of solid resist lines. The bars may alternatively be etched into the substrate. This pattern is sensitive to chromatic aberrations in the lithographic projection apparatus, particularly the projection system PL, and illumination symmetry and the presence of such aberrations will manifest themselves in a variation in the printed grating. Accordingly, the scatterometry data of the printed gratings is used to reconstruct the gratings. The parameters of the grating, such as line widths and shapes, may be input to the reconstruction process, performed by processing unit PU, from knowledge of the printing step and/or other scatterometry processes.

## Modelling

The purpose of rigorous optical diffraction theories in metrology is effectively the calculation of a diffraction spectrum that is reflected from the target. The target may be any target, whether purposely provided for measurement (e.g., a grating) or actual device structures which require measurement. Target shape information is obtained for CD (critical dimension) uniformity and overlay metrology. Overlay metrology is a measuring system in which the overlay of two targets is measured in order to determine whether two layers on a substrate are aligned or not. CD uniformity is simply a measurement of the uniformity of the grating on the spectrum to determine how the exposure system of the lithographic apparatus is functioning. Specifically, CD, or critical dimension, is the width of the object that is "written" on the substrate and is the limit at which a lithographic apparatus is physically able to write on a substrate.

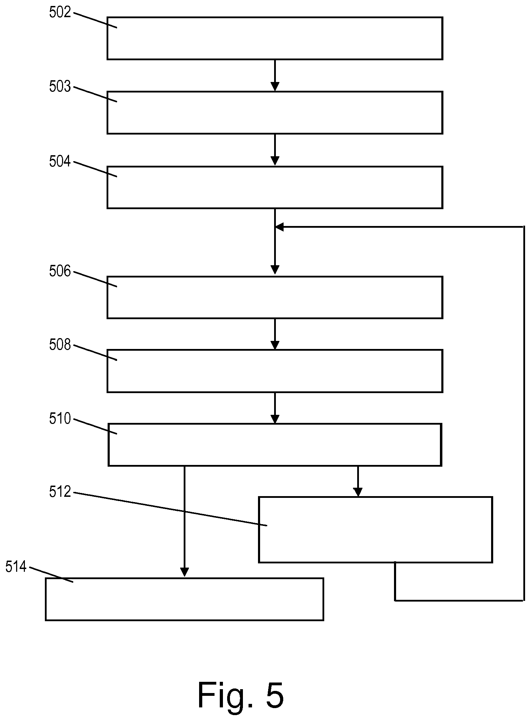

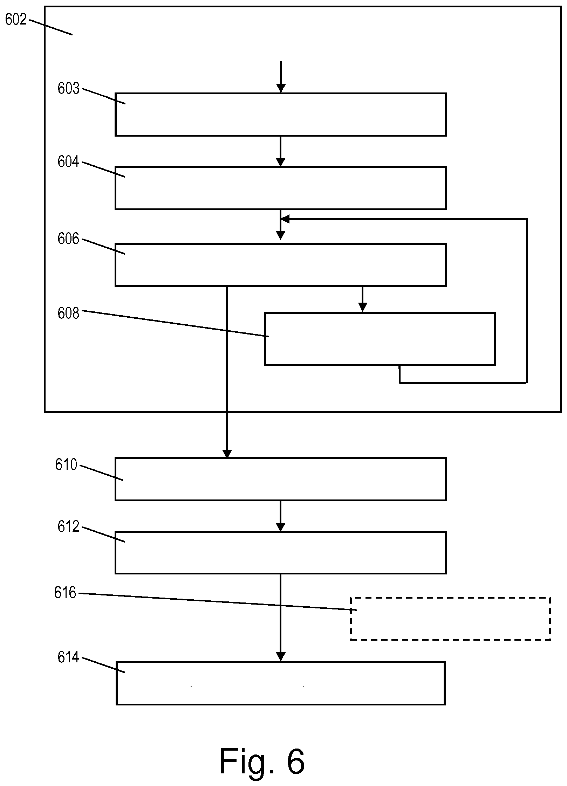

Using one of the scatterometers described above in combination with modeling of a target structure such as the target 30 and its diffraction properties, measurement of the shape and other parameters of the structure can be performed in a number of ways. In a first type of process, represented by Figure 5, a diffraction pattern based on a first estimate of the target shape (a first candidate structure) is calculated and compared with the observed diffraction pattern. Parameters of the model are then varied systematically and the diffraction re-calculated in a series of iterations, to generate new candidate structures and so arrive at a best fit. In a second type of process, represented by Figure 6, diffraction spectra for many different candidate structures are calculated in advance to create a 'library' of diffraction spectra. Then the diffraction pattern observed from the measurement target is compared with the library of calculated spectra to find a best fit. Both methods can be used together: a coarse fit can be obtained from a library, followed by an iterative process to find a best fit.

Referring to Figure 5 in more detail, the way the measurement of the target shape and/or material properties is carried out will be described in summary. The target will be assumed for this description to be a 1-dimensional (1-D) structure. In practice it may be 2-dimensional or 3-dimensional, and the processing will be adapted accordingly.

In step 502, the response, and more specifically the diffraction pattern, of the actual target on the substrate is measured using a scatterometer such as those described above. This measured diffraction pattern is forwarded to a calculation system such as a computer. The calculation system may be the processing unit PU referred to above, or it may be a separate apparatus.

In step 503, a 'model recipe' is established which defines a parameterized model of the target structure in terms of a number of parameters pi ($p_1$, $p_2$, $p_3$ and so on). These parameters may represent for example, in a 1D periodic structure, the angle of a side wall, the height or depth of a feature, the width of the feature. Properties of the target material and underlying layers are also represented by parameters such as refractive index (at a particular wavelength present in the scatterometry radiation beam). Specific examples will be given below. Importantly, while a target structure may be defined by dozens of parameters describing its shape and material properties, the model recipe will define many of these to have fixed values, while others are to be variable or 'floating' parameters for the purpose of the following process steps. For the purposes of describing Figure 5, only the variable parameters are considered as parameters $p_i$.

In step 504: A model target shape is estimated by setting initial values $p_i^{(0)}$ for the floating parameters (i.e. $p_1^{(0)}$, $p_2^{(0)}$, $p_3^{(0)}$ and so on). Each floating parameter will be generated within certain predetermined ranges, as defined in the recipe.

In step 506, the parameters representing the estimated shape, together with the optical properties of the different elements of the model, are used to calculate the scattering properties, for example using a rigorous optical diffraction method such as RCWA or any other solver of Maxwell equations. This gives an estimated or model diffraction pattern of the estimated target shape.

In steps 508 and 510, the measured diffraction pattern and the model diffraction pattern are then compared and their similarities and differences are used to calculate a "merit function" for the model target shape.

In step 512, assuming that the merit function indicates that the model needs to be improved before it represents accurately the actual target shape, new parameters $p_1^{(1)}$, $p_1^{(1)}$, $p_3^{(1)}$, etc. are estimated and fed back iteratively into step 506. Steps 506-512 are repeated.

In order to assist the search, the calculations in step 506 may further generate partial derivatives of the merit function, indicating the sensitivity with which increasing or decreasing a parameter will increase or decrease the merit function, in this particular region in the parameter space. The calculation of merit functions and the use of derivatives is generally known in the art, and will not be described here in detail.

In step 514, when the merit function indicates that this iterative process has converged on a solution with a desired accuracy, the currently estimated parameters are reported as the measurement of the actual target structure.

The computation time of this iterative process is largely determined by the forward diffraction model used, i.e. the calculation of the estimated model diffraction pattern using a rigorous optical diffraction theory from the estimated target structure. If more parameters are required, then there are more degrees of freedom (note that "parameters" in this context (degrees of freedom) are internal to the Maxwell solver and are different from, and typically many more than, the model parameters described in the above steps). The calculation time increases in principle with the power of the number of degrees of freedom.

The estimated or model diffraction pattern (or more generally, response) calculated at 506 can be expressed in various forms. Comparisons are simplified if the calculated pattern is expressed in the same form as the measured pattern generated in step 510. For example, a modeled spectrum can be compared easily with a spectrum measured by the apparatus of Figure 3; a modeled pupil pattern can be compared easily with a pupil pattern measured by the apparatus of Figure 4.

Throughout this description from Figure 5 onward, the term 'diffraction pattern' will be used, on the assumption that the scatterometer of Figure 4 is used. The skilled person can readily adapt the teaching to different types of scatterometer, or even other types of measurement instrument.

Figure 6 illustrates an alternative example process in which plurality of model diffraction patterns for different estimated target shapes (candidate structures) are calculated in advance and stored in a library for comparison with a real measurement. The underlying principles and terminology are the same as for the process of Figure 5. The steps of the Figure 6 process are:

In step 602, the process of generating the library is performed. A separate library may be generated for each type of target structure. The library may be generated by a user of the measurement apparatus according to need, or may be pre-generated by a supplier of the apparatus.

In step 603, a 'model recipe' is established which defines a parameterized model of the target structure in terms of a number of parameters pi ($p_1$, $p_2$, $p_3$ and so on). Considerations are similar to those in step 503 of the iterative process.

In step 604, a first set of parameters $p_1^{(0)}$, $p_2^{(0)}$, $p_3^{(0)}$, etc. is generated, for example by generating random values of all the parameters, each within its expected range of values.

In step 606, a model diffraction pattern is calculated and stored in a library, representing the diffraction pattern expected from a target shape represented by the parameters.

In step 608, a new set of parameters $p_1^{(1)}$, $p_2^{(1)}$, $p_3^{(1)}$, etc. is generated. Steps 606-608 are repeated tens, hundreds or even thousands of times, until the library which comprises all the stored modeled diffraction patterns is judged sufficiently complete. Each stored pattern represents a sample point in the multi-dimensional parameter space. The samples in the library should populate the sample space with a sufficient density that any real diffraction pattern will be sufficiently closely represented.

In step 610, after the library is generated (though it could be before), the real target 30 is placed in the scatterometer and its diffraction pattern is measured.

In step 612, the measured pattern is compared with the modeled patterns stored in the library to find the best matching pattern. The comparison may be made with every sample in the library, or a more systematic searching strategy may be employed, to reduce computational burden.

In step 614, if a match is found then the estimated target shape used to generate the matching library pattern can be determined to be the approximate object structure. The shape parameters corresponding to the matching sample are output as the measured shape parameters. The matching process may be performed directly on the model diffraction signals, or it may be performed on substitute models which are optimized for fast evaluation.

In step 616, optionally, the nearest matching sample is used as a starting point, and a refinement process is used to obtain the final parameters for reporting. This refinement process may comprise an iterative process very similar to that shown in Figure 5, for example.

In the above modelling methods, the relationship between the parameter values and the calculated pupil may evaluated numerically by a forward solver, which consists of a slicer (constructing a concrete geometry description given the geometric model and a set of parameter values) and a Maxwell solver (solving the electromagnetic scattering problem given the concrete geometry description). Defining the parametrized geometric model (e.g., at steps 503, 603 above) by constructing it directly from basic shapes is complicated. Therefore, it is often preferred to define the parametrized geometric model in terms of geometric procedures which might mimic the formation of the structures in the manufacturing process. As such, the parametrized geometric model may be defined specifically for each structure (e.g., stack) in terms of a combination of explicit geometric elements (e.g., "add a brick of dimensions ABC and material M at position XYZ") and process steps (e.g., the liner process: "add a conformal deposition layer of material A and thickness X on top of all exposed surfaces").

However, Maxwell solvers used in semiconductor stack modelling vertically discretize the geometry into a number of so-called slices. It is required that the topology of the geometry within each slice is constant. In particular, the slicer is forced to introduce a slice cut at each kink / corner in the geometry. Every additional slice increases the computational cost of the Maxwell solver, because its accurate numerical representation necessitates the introduction of additional degrees of freedom as already mentioned above. Furthermore, a precondition for finding the best fit of the calculated pupil to the measured pupil by an iterative procedure (inverse solver), such as described by steps 504-514 and step 616, is that the relationship between the parameter values and the calculated pupil (the forward model) is continuous; this is especially true if the inverse solver uses derivatives of the merit function as is described above as an option for step 506. Moreover, any discontinuities in this relationship will increase the density of sample points required to construct an accurate library, such as is described in relation to step 608.

One implementation of a liner process shifts all faces of an existing geometric element outward by a fixed distance (offset contour). The additional volume thus constructed is filled with the material of the deposition layer. This method has two essential drawbacks:

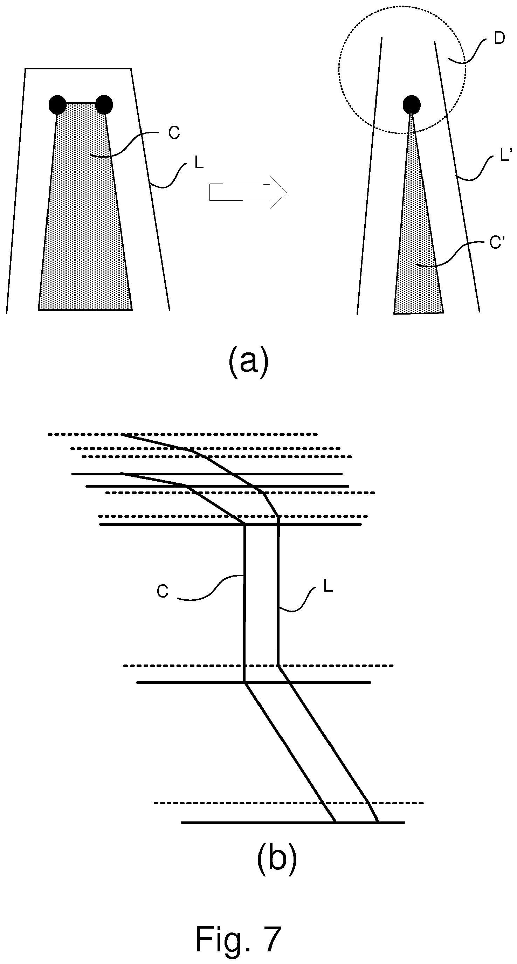

○ A very small change in the geometry of the original shape can cause a step change in the volume of the constructed deposition layer, as shown in Figure 7(a). This effect results in a discontinuity in the relation between parameter values and the calculated pupil, which greatly increases the risk that the inverse solver gets struck in a local minimum of the merit function and returns inferred parameter values which represent a suboptimal fit to the measured pupil. The left drawing shows the original contour C and modeled deposition layer L in a situation where there is no artifact, and the right drawing shows an altered contour C' which has resulted in an artifact D ("miter") in the modeled deposition layer L'. This artifact D, seen near sharp corners in the original geometry, is a disadvantage of the offset contour approach. However, it could in principle be mitigated by somehow truncating the miter to a fixed maximum length. The key point of this example is that, at the point in parameter space where there is a transition from the situation on the left-hand side to the situation on the right-hand side, i.e. when the two vertices merge, there is a step change in the shape and volume enclosed by the offset contour. This step change in volume causes a step change in the calculated pupil even though it might have been triggered by only a very small change in a model parameter (e.g. the side-wall angle or bottom CD of the line shown, or the horizontal position of another element which subtracts from the line). In other words, there is a discontinuity in the relation between the model parameter and the calculated pupil.

○ Since the intersection points (vertices) of the offset planes lie on a different vertical level than the vertices of the original shape, additional slices are introduced for all new intersection points. This is illustrated in Figure 7(b), which shows the contour C and a modeled deposition layer L. Each solid horizontal layer represents a slice for the original contour C, while the dotted lines represent the additional slices required for the modeled deposition layer L. In complex 3D geometries, and/or multiple deposition layers, an arbitrary number of additional slices may be generated for each existing slice. This is sometimes referred to as slice explosion.

An alternative known approach constructs the deposition layer by simply scaling the existing geometric shape by a constant factor (scaling). This approach also suffers from the slice explosion issue mentioned above and has the additional problem that the thickness of the deposited layer in the model can become very uneven.

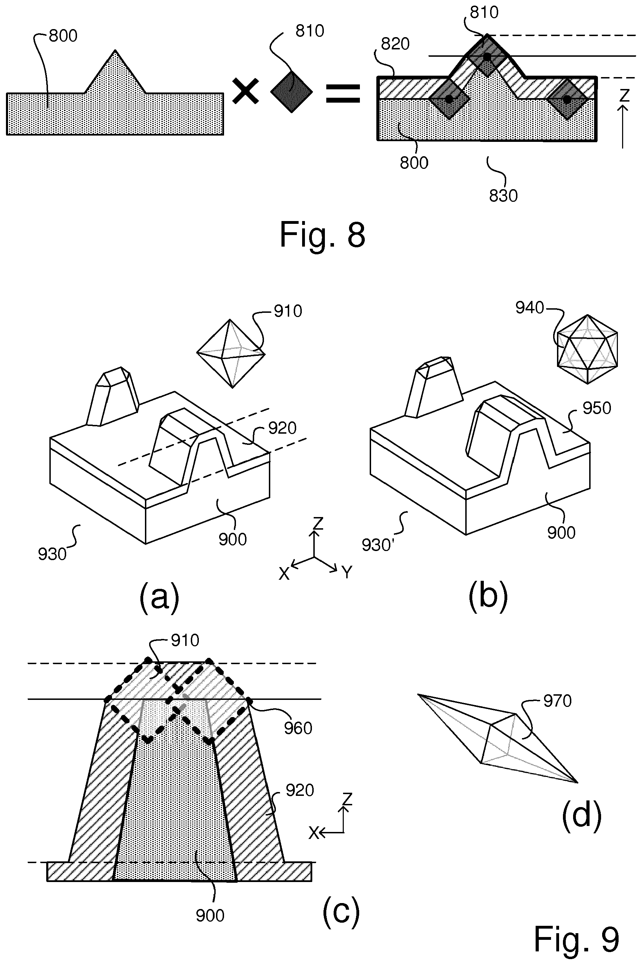

It is therefore proposed to construct the process step as a Minkowski sum (MS) of the relevant geometric shapes of the existing stack geometry and a special fixed shape, referred to herein as the kernel. The kernel can be any shape; its form and size determine the specific properties if the process. If the kernel is chosen to be a polytope that, to a greater or lesser degree, approximates a sphere (e.g., a regular octahedron), the result is a geometric operation which mimics a conformal liner process, as is illustrated Figure 8. However, the concepts herein are not so limited; depending on the application, other kernel shapes may be used. Such kernels may comprise non-polytope 3D shapes (e.g., a sphere, ovoid or a more complex shape), 2D shapes or 1D shapes.

Minkowski sums are useful geometric operations that can be used to *fatten* objects in appropriate ways. The definition of a Minkowski sum assumes that the polygons/polytopes A and B have been positioned on a coordinate system:

$$A + B = \{x + y | x \in A, y \in B\}$$

where x+y is the vector sum of two points. Thinking of this in terms of translation, the Minkowski sum is the union of all translations of A by a point defined within B.

Figure 8 illustrates the basic process in a 2D example. It shows a representation of the source material(s) 800, defining an original contour, and a kernel 810. The Minkowski sum 830 of the source material(s) 800 and the kernel 810 approximates a deposition process by defining a deposition layer 820 on source material(s) 800. The kernel 810 is shown at three arbitrary points on the surface contour of source material(s) 800 of the Minkowski sum 830, for illustration of the basic concept.

Figure 9 illustrates the same basic process in two 3D examples. In a first 3D example illustrated in Figure 9(a), the Minkowski sum 930 of the source material(s) 900 and a 3D kernel 910 (not shown to the same scale) defines deposition layer 920 in a manner similar to the 2D example of Figure 8. Figure 9(b) shows the same process on the same source material(s) 900, but using a different kernel 940. The kernel 910 is an octahedral bipyramid, and kernel 940 is a (convex) regular isocahedron. Comparison of the Minkowski sum 930 of Figure 9(a) and Minkowski sum 930' of Figure 9(b) illustrates one effect of kernel selection, which may be a compromise between complexity and optimal deposition layer contour. Assuming a 3D isotropic example, the closer that the kernel approximates a sphere, the more optimally the deposition layer will mimic a conformal liner process. This can be seen by comparing the contour of deposition layer 950 to that of deposition layer 920. However, simpler kernels with fewer vertices will minimize the number of slices and therefore the complexity of the Maxwell solver calculation.

In particular, a kernel having vertices on only one horizontal (XY) plane may be preferred. More specifically, the kernel may comprise a polytope kernel which approximates a bicone, e.g., a regular bipyramid, as such a shape minimizes the number of additional slices required. Similarly, in a 2D process, a rhombus kernel (e.g., a square kernel having its diagonals on the main axes) may be a preferred for the same reason. In this manner, any new vertices will be at a fixed vertical distance with respect to the vertices of the original shape and therefore many of the new vertices will lie on the same horizontal planes. This can be seen in Figure 9(c), which is a 2D cross-sectional detail of Figure 9(a). This shows that the intermediate vertices 960 of the deposition layer 920 lie on the same plane as an already existing slice (indicated by the solid horizontal line), i.e., coincide vertically with vertices of the original contour 900. This minimizes the additional slices required to two (the minimum number of additional slices assuming a non-flat surface), i.e., the dotted horizontal lines shown in Figures 9(a) and 9(c). By comparison, the deposition layer 950 of Figure 9(b) has introduced more than two additional slices. Similarly, the 2D example illustrated in Figure 8 uses a rhombus kernel and therefore again only introduces two additional slices (the dotted horizontal lines), with the additional intermediate vertices lying on the already existing slice described by the solid horizontal line.

In some cases, the process being mimicked by the Minkowski sum algorithm described herein comprises an anisotropic process (e.g., a crystal growth process). For such processes, an anisotropic kernel 970 may be used to better approximate the process. Figure 9(d) shows an exemplary anisotropic kernel 970.

It should be appreciated that the Minkowski sum shape 830, 930, 930' is a function only of the volume elements of the original shape 800, 900 and does not depend on the manner in which the boundary of the original shape 800, 900 is parametrized. As such, the Minkowski sum contour deforms continuously under continuous deformations of the original contour, under very general assumptions. This gives a continuous relationship between the model parameters and the calculated pupil, as is required in order for the inverse solver to work robustly and efficiently. This property eliminates the risk that varying the model parameters causes a discontinuous jump in the volume of the deposition layer.

The shape of the kernel can be chosen to be inter alia any 3D, 2D, or 1D polytope, and different sets of materials in the original stack geometry may be taken together to form the source shape for the Minkowski sum. The kernel can be a negative kernel (or "air kernel" as it effectively replaces the initial source material with air) which removes a layer from the original contour (e.g., mimics an etch process rather than a deposition process). This freedom allows modeling of other process steps, such as rounding (e.g., in the XY plane) or double patterning, using (one or multiple iterations of) the same basic MS algorithm, as will be described.

Multiple iterations of the Minkowski sum algorithm may be used to determine multiple deposition layers (a multi-layered liner). For each successive layer, the kernel shape may be changed, e.g., to alternate between a bipyramidal kernel (e.g., kernel 910) and a more spherical kernel (e.g., kernel 940). This alternation between kernels can be used to obtain a good rounding of the multi-layered liner, rather than a pyramid shape.

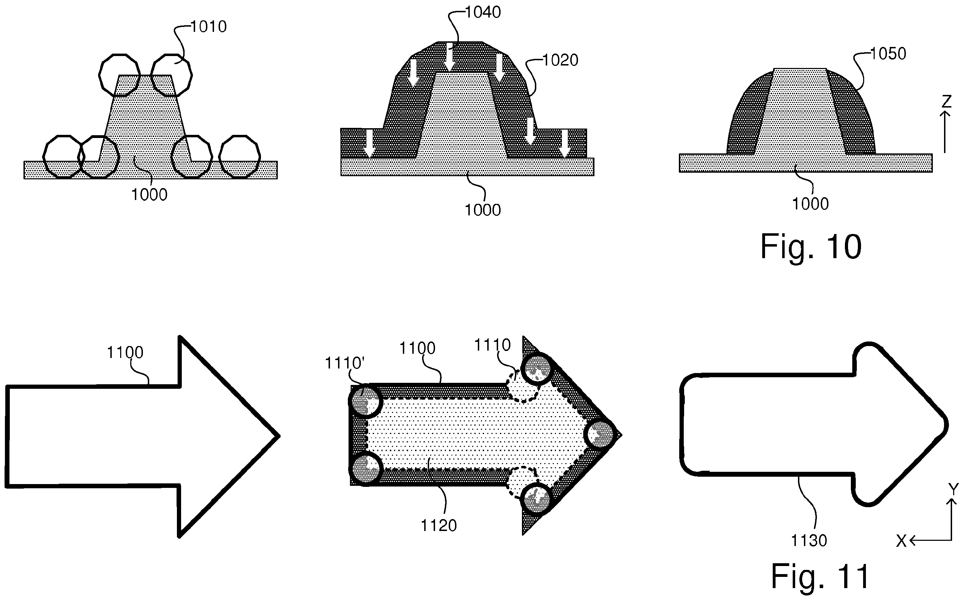

Figure 10 illustrates a further application of the Minkowski sum algorithm, such as that described herein, which can be used to approximate a double-patterning process and therefore construct a parameterized model of a device formed from such a process. This can be achieved, for example, by using two iterations of the Minkowski sum algorithm. In the first iteration, the original shape 1000 is expanded in all directions using a 3D sphere-like kernel 1010 to determine an intermediate deposition layer 1020. In the second iteration, the intermediate deposition layer 1020 is shrunk by applying a negative 1D kernel, represented by arrows 1040, thereby mimicking a vertical etch step so as to obtain final deposition layer 1050.

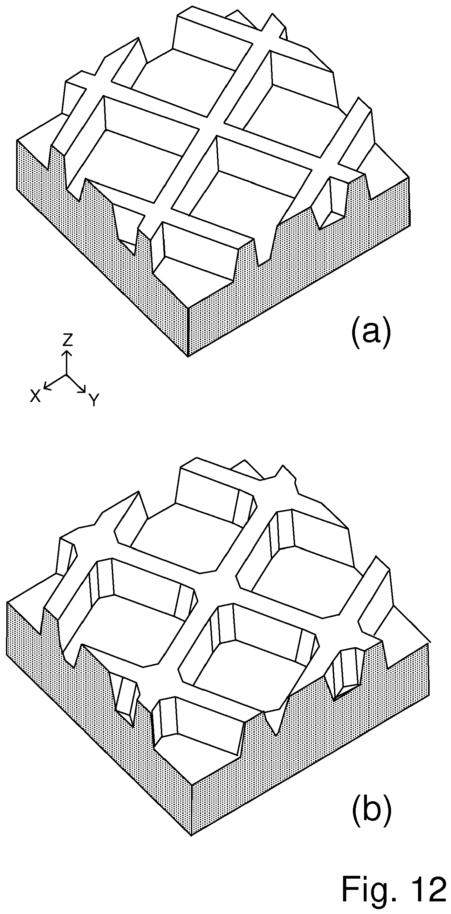

Figure 11 illustrates another application of the Minkowski sum algorithm which mimics a rounding process as may actually be observed in manufacturing (even where not actually designed), and therefore enables construction of a more representative model. In particular, the rounding process may be a 2D rounding process in the XY plane. This can be achieved, for example, by performing two iterations of the Minkowski sum algorithm using a circle-shaped (or a polygon which approximates a circle) kernel 1110. In a first iteration, the original shape 1100 is shrunk by applying the Minkowski sum algorithm to the outside of the shape 1100, using a negative kernel 1110 (dotted line). The result is an intermediate shape 1120. In the second iteration, the Minkowski sum algorithm is applied to the intermediate shape 1120 using positive kernel 1110' (solid line) to obtain the final shape 1130. The final shape 1130 resembles the original shape 1100, but with all convex corners having been rounded. Figure 12 shows this XY rounding process as applied to a simple periodic geometry. Figure 12(a) shows an example of a periodic geometry before the rounding process is applied and Figure 12(b) shows the result of the XY rounding process.

The Minkowski sum process described herein can be used to define a large number of relevant process steps (liner, XY rounding, 3D rounding, double patterning, directional etch, crystal growth) by applying the process one or more times (i.e., in one or more iterations), possibly combining multiple kernels. The kernels may comprise different shapes and/or materials as appropriate for the application. These compound processes retain the favorable properties of the basic Minkowski sum process. These compound processes retain the key properties of being continuous in parameter space and (depending on the kernel chosen) of minimizing the number of additional slices introduced. The method is systematically improvable. The idealized conformal liner process can be approximated arbitrarily closely (at the cost of introducing some additional slices) by choosing a kernel which is a close approximation of the sphere. This trade-off can be made on a case-by-case basis.

Embodiments of the present invention may be implemented in accordance with the reconstruction methods described with reference to Figures 5 and 6. In particular, the methods described herein may be used in step 503 or step 603 to define the initial parameterized geometric model.

Embodiments of the present invention may be implemented by implementing the methods described herein on the processing units PU described with reference to Figures 3 and 4 to provide an inspection apparatus for reconstructing an approximate structure of an object.

The processors described with reference to Figures 3 or 4 may operate under the control of computer programs containing one or more sequences of machine-readable instructions for calculating electromagnetic scattering properties of a structure, the instructions being adapted to cause one or more processors to perform the methods described herein.

Although specific reference may be made in this text to the use of inspection apparatus in the manufacture of ICs, it should be understood that the inspection apparatus described herein may have other applications, such as the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The methods according to embodiments of the present invention described above may be incorporated into the forward diffraction model for reconstructing an approximate structure of an object from a detected electromagnetic scattering property, such as a diffraction pattern, arising from illumination of the object by radiation, as described above with reference to Figures 5 and 6. The processing unit PU described above with reference to Figures 3 and 4 may be configured to reconstruct an approximate structure of an object using this method.

Further embodiments according to the present invention are further described in below numbered clauses:

1. A method for constructing a parameterized geometric model of a structure comprising:

determining an initial contour defining a modeled surface of the structure; and
determining an output contour defining the modeled surface of the structure as a Minkowski sum of the initial contour and a kernel.

2. A method according to clause 1, wherein the kernel comprises a 2-dimensional convex polygon.

3. A method according to clause 2, wherein the kernel comprises an approximation of a circle.

4. A method according to clause 2, wherein the kernel comprises a rhombus having its diagonals aligned with vertical and horizontal axes of the parameterized geometric model.

5. A method according to clause 1, wherein the kernel comprises a 3-dimensional convex polytope.

6. A method according to clause 5, wherein the kernel comprises an approximation of a sphere.

7. A method according to clause 5, wherein the kernel comprises an approximation of a bicone.

8. A method according to clause 7, wherein the kernel comprises a regular convex bipyramid.

9. A method according to any preceding clause, wherein the kernel is anisotropic so as to mimic an anisotropic process.

10. A method according to clause 1, wherein the kernel comprises a 1-dimensional shape.

11. A method according to any preceding clause, wherein the kernel is a negative kernel.

12. A method according to any preceding clause, wherein the step of determining an output contour is operable to mimic performance of a process step on the initial contour.

13. A method according to clause 12, wherein the process step comprises one or more of:

defining a liner, rounding in the XY plane, 3D rounding, double patterning, directional etch and crystal growth.

14. A method according to any preceding clause, comprising performing multiple iterations of the method, with the initial contour of each successive iteration comprising the output contour of the immediately preceding iteration.

15. A method according to clause 14, wherein the shape and/or number of dimensions of the kernel is varied for at least one of the multiple iterations.

16. A method according to clause 14 or 15, comprising modeling a rounding process using at least two of said iterations comprising:

a first iteration on the initial contour using a negative circular or spherical kernel, or a polygon/polytope approximation thereof; and

a second iteration using a positive circular or spherical kernel, or a polygon/polytope approximation thereof.

17. A method according to clause 14 or 15, comprising modeling a double patterning process using at least two of said iterations comprising:

a first iteration on the initial contour using a positive spherical kernel, or a or a polygon/polytope approximation thereof; and

a second iteration using a one-dimensional negative kernel aligned with an etch direction of an etch process forming part of the double patterning process.

18. A method of measuring a geometric parameter of a structure on a substrate comprising:

obtaining a measured response from measurement of the structure;

constructing a parameterized geometric model of the structure using the method of any preceding clause;

determining an estimated response relating to the parameterized geometric model; and

varying one or more parameters of the parameterized geometric model to minimize the difference between the measured response and the estimated response.

19. A method according to clause 18, wherein the measured response comprises a measured diffraction pattern and the estimated response comprises an estimated diffraction pattern.

20. A method according to clause 18 or 19, wherein said determining an estimated response comprises using a Maxwell solver.

21. An inspection apparatus comprising:

projection optics for projecting measurement radiation onto a structure on a substrate;

a detection arrangement operable to obtain a measured response resultant from scattering of said measurement radiation by said structure;

and

a processor operable to:

construct a parameterized geometric model of the structure using the method of any of clauses 1 to 17; determine an estimated response relating to the parameterized geometric model; and

vary one or more parameters of the parameterized geometric model to minimize the difference between the measured response and the estimated response.

22. An inspection apparatus according to clause 21, wherein the measured response comprises a measured diffraction pattern and the estimated response comprises an estimated diffraction pattern.

23. An inspection apparatus according to clause 21 or 22, wherein said determining an estimated response comprises using a Maxwell solver.

24. A computer program product containing one or more sequences of machine-readable instructions, the instructions being adapted to cause one or more processors to perform a method according to any of clauses 1 to 20.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The term "electromagnetic" encompasses electric and magnetic.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g., semiconductor memory, magnetic or optical disk) having such a computer program stored therein.

It is to be appreciated that the Detailed Description section, and not the Summary and Abstract sections, is intended to be used to interpret the claims. The Summary and Abstract sections may set forth one or more but not all exemplary embodiments of the present invention as contemplated by the inventor(s), and thus, are not intended to limit the present invention and the appended claims in any way.

The present invention has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method for constructing a parameterized geometric model of a structure comprising:

    determining an initial contour defining a modeled surface of the structure; and
    determining an output contour defining the modeled surface of the structure as a Minkowski sum of the initial contour and a kernel.

2. A method as claimed in claim 1, wherein the kernel comprises a 2-dimensional convex polygon.

3. A method as claimed in claim 1, wherein the kernel comprises a 3-dimensional convex polytope.

4. A method as claimed in any preceding claim, wherein the kernel is anisotropic so as to mimic an anisotropic process.

5. A method as claimed in claim 1, wherein the kernel comprises a 1-dimensional shape.

6. A method as claimed in any preceding claim, wherein the kernel is a negative kernel.

7. A method as claimed in any preceding claim, wherein the step of determining an output contour is operable to mimic performance of a process step on the initial contour.

8. A method as claimed in claim 7, wherein the process step comprises one or more of:

    defining a liner, rounding in the XY plane, 3D rounding, double patterning, directional etch and crystal growth.

9. A method as claimed in any preceding claim, comprising performing multiple iterations of the method, with the initial contour of each successive iteration comprising the output contour of the immediately preceding iteration.

10. A method as claimed in claim 9, wherein the shape and/or number of dimensions of the kernel is varied for at least one of the multiple iterations.

11. A method as claimed in claim 9 or 10, comprising modeling a rounding process using at least two of said iterations comprising:

    a first iteration on the initial contour using a negative circular or spherical kernel, or a polygon/polytope approximation thereof; and
    a second iteration using a positive circular or spherical kernel, or a polygon/polytope approximation thereof.

12. A method as claimed in claim 9 or 10, comprising modeling a double patterning process using at least two of said iterations comprising:

    a first iteration on the initial contour using a positive spherical kernel, or a or a polygon/polytope approximation thereof; and
    a second iteration using a one-dimensional negative kernel aligned with an etch direction of an etch process forming part of the double patterning process.

13. A method of measuring a geometric parameter of a structure on a substrate comprising:

obtaining a measured response from measurement of the structure;

constructing a parameterized geometric model of the structure using the method of any preceding claim;

determining an estimated response relating to the parameterized geometric model; and

varying one or more parameters of the parameterized geometric model to minimize the difference between the measured response and the estimated response.

14. An inspection apparatus comprising:

projection optics for projecting measurement radiation onto a structure on a substrate;

a detection arrangement operable to obtain a measured response resultant from scattering of said measurement radiation by said structure; and

a processor operable to:

construct a parameterized geometric model of the structure using the method of any of claims 1 to 12;

determine an estimated response relating to the parameterized geometric model; and

vary one or more parameters of the parameterized geometric model to minimize the difference between the measured response and the estimated response.

15. A computer program product containing one or more sequences of machine-readable instructions, the instructions being adapted to cause one or more processors to perform a method according to any of claims 1 to 13.

# Fig. 1

# Fig. 2

# Fig. 3

SM1

2

10

4

PU

W

I

λ

Z

X

# Fig. 4

18

PU

11

SM2

12

13

17

14

F

15

16

30

W

2

Fig. 5

Fig. 6

(a)

(b)

Fig. 7

Fig. 8

(a)

(b)

(c)

(d)

Fig. 9

Fig. 10

Fig. 11

EP 3 514 629 A1

(a)

(b)

Fig. 12

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 405 106 A2 (IBM [US]) 2 January 1991 (1991-01-02) * page 4, line 34 - page 6, line 46; claims 20-26; figures 7-10 * ----- | 1-15 | INV. G03F7/20 |
| X | EP 0 280 968 A2 (IBM [US]) 7 September 1988 (1988-09-07) * the whole document * ----- | 1-15 | |

TECHNICAL FIELDS
SEARCHED      (IPC)

G03F

The present search report has been drawn up for all claims

| Place of search | Date of completion of the search | Examiner |
|---|---|---|
| Munich | 15 August 2018 | Angioni, Catherine |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 .....................................................................................................

& : member of the same patent family, corresponding
    document

EPO FORM 1503 03.82 (P04C01)

**EP 3 514 629 A1**

## ANNEX TO THE EUROPEAN SEARCH REPORT
## ON EUROPEAN PATENT APPLICATION NO.

EP 18 15 2891

This annex lists the patent family members relating to the patent documents cited in the above-mentioned European search report.
The members are as contained in the European Patent Office EDP file on
The European Patent Office is in no way liable for these particulars which are merely given for the purpose of information.

15-08-2018

| Patent document cited in search report | | Publication date | Patent family member(s) | | Publication date |
|---|---|---|---|---|---|
| EP 0405106 | A2 | 02-01-1991 | EP | 0405106 A2 | 02-01-1991 |
| | | | JP | H0350679 A | 05-03-1991 |
| | | | JP | H0786885 B2 | 20-09-1995 |
| | | | US | 5159512 A | 27-10-1992 |
| EP 0280968 | A2 | 07-09-1988 | DE | 3852328 D1 | 19-01-1995 |
| | | | DE | 3852328 T2 | 24-05-1995 |
| | | | EP | 0280968 A2 | 07-09-1988 |
| | | | JP | H077426 B2 | 30-01-1995 |
| | | | JP | S63217473 A | 09-09-1988 |
| | | | US | 4785399 A | 15-11-1988 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• EP 1628164 A